# EUROPEAN PATENT APPLICATION

(11) **EP 2 077 702 A2**
(43) Date of publication of application: **08.07.2009**
(21) Application number: 08166020.1
(22) Date of filing: 07.10.2008
(51) Int. Cl.: H05K 1/11

(54) **Wiring board and manufacturing method thereof and wiring board assembly**

(30) Priority: 07.01.2008 JP 2008000778
(71) Applicant: Fujitsu Ltd., Kawasaki-shi, Kanagawa 211-8588 (JP)
(72) Inventor: Sugane, Mitsuhiko, Fujitsu Advanced Technologies Limited, Kawasaki-shi, Kanagawa 211-8588 (JP)
(74) Representative: Wilding, Frances Ward

(57) **Abstract**

A wiring board has a substrate having a first surface and a second surface opposite to the first surface, at least one wiring layer being formed between the first surface and the second surface. A non-through hole is formed in the substrate with a depth from the first surface to reach the wiring layer, an inner surface of the non-through hole being plated. A vent hole is formed in the substrate to extend between an end of the non-through hole and the second surface of the substrate. A plated portion of the non-through hole is connected to the wiring layer. An inner diameter of the vent hole is smaller than an inner diameter of the plated portion of the non-through hole.

## Description

### FIELD

The present invention relates to a wiring board and a manufacturing method thereof.

### BACKGROUND

In a multilayer wiring board, in order to electrically connect a plurality of conductive layers to each other or to acquire electrical conduction with a conductive layer in a substrate, a though hole is used in many cases. The through hole penetrates the substrate and extends perpendicularly between both sides of the substrate. An inner surface of the through hole is plated so as to achieve electrical connection.

A multilayer wiring board having through holes formed therein is used for an electric circuit of equipments of high-speed transmission use. Because a radio frequency electric signal for high-speed transmission use is given a large influence by a wiring length of a signal path, the wiring length on a wiring board is designed so that the wiring length does not give an influence to the radio frequency electric signal.

Plating provided on an inner surface of a through hole is also a part of wiring, and may affect a high frequency electricity signal. For example, if one of surfaces (front surface) of a wiring board is connected to a conductive layer inside the wiring board by a though hole, a portion from the inner conductive layer to the other one of the surfaces (back surface) is an unnecessary portion. If a radio frequency signal propagates to the plating of the unnecessary portion, a reflection of the signal occurs, which gives a bad influence to a signal transmission characteristic. Accordingly, it is desirable to eliminate the unnecessary portion of the plating of the through hole.

There are many cases in which a connector pin is inserted and mounted to the above-mentioned through hole. A generally used connector pin for electric circuits has a length almost the same as a thickness of a wiring board, and is inserted into the through hole over almost its entirety. However, the connector pin for high frequency signals is preferably shorter than a generally used connector, and a connector having a length reaching a middle of the through hole is used for such a connector pin for high frequency signals.

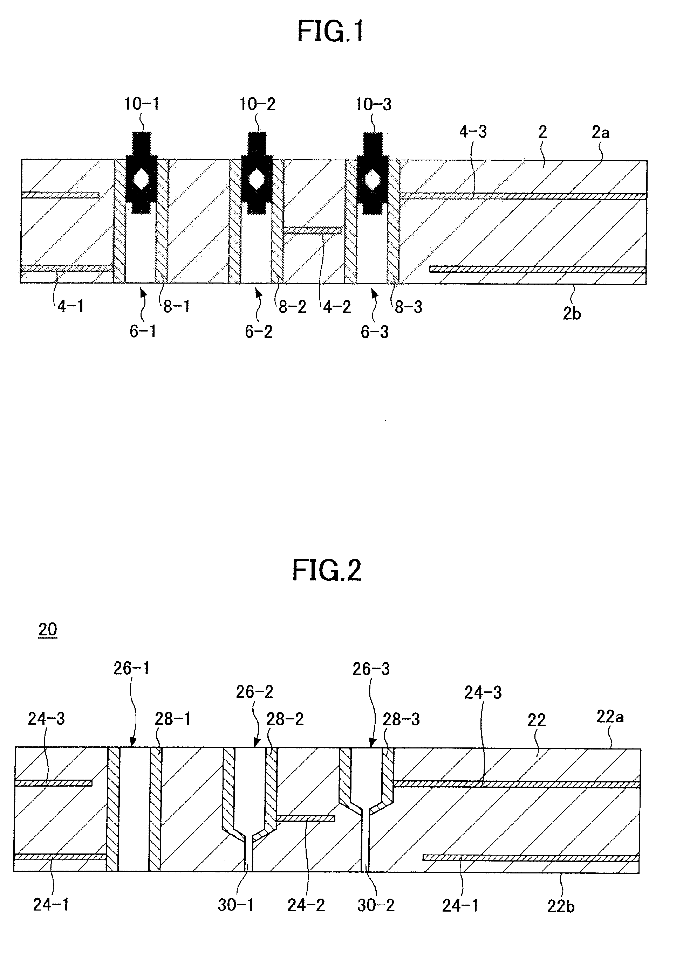

FIG. 1 is a cross-sectional view of a wiring board having a radio frequency connector pin press fitted and mounted to a through hole penetrating the wiring board. The wiring board illustrated in FIG. 1 includes a multilayer board 2 in which a plurality of wiring layers 4-1, 4-2 and 4-3 are formed. Through holes 6-1, 6-1 and 6-3 extend by penetrating the multilayer board 2, and are provided with platted layers (plated portions) 8-1, 8-2 and 8-3 over inner surfaces thereof, respectively. The plated layer 8-1 of the through hole 6-1 is selectively connected to the wiring layer 4-1, the plated layer 8-2 of the through hole 6-2 is selectively connected to the wiring layer 4-2, and the plated layer 8-3 of the through hole 6-3 is selectively connected to the wiring layer 4-3.

Connector pins 10-1, 10-2 and 10-3 are press fitted in the through holes 6-1, 6-2 and 6-3, respectively. The connector pins 10-1, 10-2 and 10-3 are connector pins for radio frequency signals, and are shorter than a generally used connector pin. Viewing the through hole 6-1, the wiring layer 4-1 is located in a portion near a back surface 2b opposite to a front surface 2a, which is a side where the connector pin 10-1 is press fitted, and almost the entire plated layer 8-1 of the through hole 6-1 serves as a signal transmission path.

On the other hand, viewing the through hole 6-2, the wiring layer 4-2 connected to the through hole 6-2 is located in a middle of the multilayer board 2, and a portion where the connector pin 10-2 is press fitted does not reach the wiring layer 4-2. In this case, a portion of the plated layer 8-2 from a position, where the wiring layer 4-2 is connected, to the back surface 2b does not serve as a signal transmission path, and such a portion is an unnecessary conductive portion. Further, viewing the through hole 6-3, although the wiring layer 4-3 connected to the through hole 6-3 is located in a portion closer to the front surface 2a than the middle of the multilayer board 2, a portion where the connector pin 10-3 is press fitted does not reach the wiring layer 4-3. In this case, a portion of the plated layer 8-3 from a position, where the wiring layer 4-3 is connected, to the back surface 2b does not serve as a signal transmission path, and such a portion is an unnecessary conductive portion.

The above-mentioned portions of the through holes 6-2 and 6-3 where plating is unnecessary may give a bad influence to the signal transmission characteristic, and it is desirable to eliminate such an unnecessary portion. That is, for example, when a radio frequency signal propagates to the wiring layer 4-2 from the connector pin 10-2 through the plated layer 8-2, the radio frequency signal propagates to the end surface on the back surface 2b side of the multilayer substrate 2, and is reflected at the end surface of the plated layer 8-2 and returns toward the connector pin 10-2. The reflected and returned radio frequency signal may interfere with a radio frequency signal propagating to the connector pin 10-2, which may deteriorate the signal transmission characteristic. Accordingly, it is desirable to eliminate the portions of the plated layer 8-2 and 8-3 of the through holes 6-2 and 6-3, which portions do not serve as signal transmission paths.

Thus, it is considered to make each of the through holes 6-2 and 6-3 as a non-through hole, which does not penetrate the multilayer substrate 2 and has a depth just reach the wiring layer to be connected. It has been suggested to provide a non-through hole in a substrate (for example, refer to Patent Documents 1, 2 and 3). Here, the term "through hole" means a hole or opening for electrically connecting wiring layers in a substrate by plating provided on an inner surface thereof, and it does not always mean a hole or opening that penetrates and extends between front and back surfaces of a substrate. In the present specification, a hole or opening penetrating and extending between front and back surfaces of a substrate may be referred to as a through hole, and a hole or opening having a depth to a middle of a substrate may be referred to as a non-through hole.

In the meantime, in order to selectively forming a through hole and a non-through hole in a substrate, a manufacturing process of the substrate may become complex. Additionally, if a processing liquid enters a non-through hole in a manufacturing process after the non-through hole is formed in a substrate, the processing liquid may remain in the non-through hole, which may cause a corrosion of plating.

Thus, it is suggested to make all holes or openings into through holes and remove unnecessarily plated portion after forming the through holes (for example, refer to Patent Document 4). In order to remove an unnecessarily plated portion, there is used a method of cutting a plated portion from a back surface side of a substrate using a drill having a diameter larger than a diameter of a through hole. Such a method is generally referred to as a back drill.

Patent Document 1: Japanese Laid-Open Patent Application No. 2002-198461

Patent Document 2: Japanese Laid-Open Patent Application No. 08-8538

Patent Document 3: Japanese Laid-Open Patent Application No. 2001-217540

Patent Document 4: United States Patent No. 6,663,442

When cutting and removing the unnecessary portion of the plated layer of the through hole using the back drill, fine scraps of the plated portion may be formed. Because the scraps of the plated portion have electrical conductivity, the scraps may short-circuit the wirings of the substrate.

Moreover, because the portion cut and removed by the back drill forms an empty space including the penetrating through hole, a wiring layer cannot be provided in such an empty space. Thus, an area where wiring layers can be formed is reduced, which may prevent wirings from being provided efficiently.

Furthermore, because the plated portion is removed by the back drill after plating the through hole, a portion of the through hole, which does not require plating, is unnecessarily plated, which results in an unnecessary consumption of a plating material.

### SUMMARY

It is an object of the present invention to provide a technique to form a non-through hole having a necessary depth without removing a plated layer so as to prevent unnecessary plating being applied while preventing a cleaning liquid or a processing liquid from remaining in the non-through hole.

According to an aspect of the embodiment, a wiring board includes: a substrate having a first surface and a second surface opposite to the first surface, at least one wiring layer being formed between the first surface and the second surface; and at least one non-through hole formed in the substrate with a depth from the first surface to reach the wiring layer, an inner surface of the non-through hole being plated, wherein a vent hole is formed in the substrate to extend between an end of the non-through hole and the second surface of the substrate; a plated portion of the non-through hole is connected to the wiring layer; and an inner diameter of the vent hole is smaller than an inner diameter of the plated portion of the non-through hole.

Additional objects and advantages of the embodiment will be set forth in part in the description which follows, and in part will be obvious from the description, or may be learned by practice of the invention. The object and advantages of the embodiment will be realized and attained by means of the elements and combinations particularly pointed out in the appended claims.

It is to be understood that both the foregoing general description and the following detailed description are exemplary explanatory only and are not restrictive of the invention, as claimed.

### BRIEF DESCRIPTION OF DRAWINGS

FIG. 1 is a cross-sectional view of a wiring board having a radio frequency connector pin press fitted and mounted to a through hole penetrating the wiring board;
FIG. 2 is a cross-sectional view of a part of a wiring board according to an embodiment;
FIG. 3 is a cross-sectional view illustrating the wiring board illustrated in FIG. 2 in a middle of a manufacturing process;
FIG. 4 is a cross-sectional view of the wiring board having connector pins press fitted in a through hole and a non-though hole;
FIG. 5 is an illustration of a manufacturing process of a wiring board having a non-through hole;
FIG. 6 is a side view of a wiring board assembly; and
FIG. 7 is an enlarged cross-sectional view of a part encircled by a circle A in FIG. 6.

### DESCRIPTION OF EMBODIMENT

Preferred embodiment of the present invention will be explained with reference to the accompanying drawings.

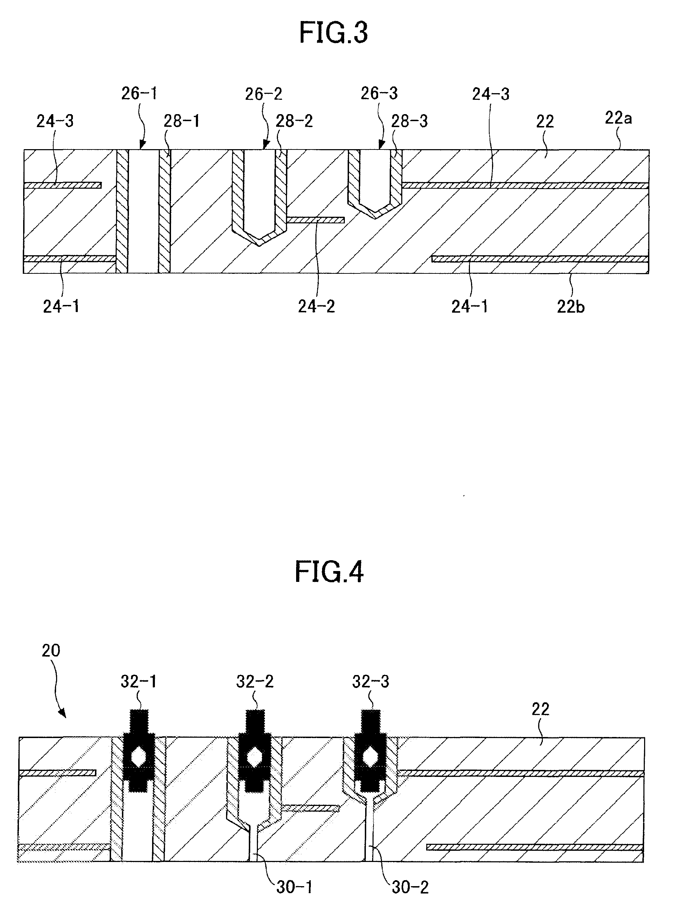

FIG. 2 is a cross-sectional view of a part of a wiring board according to an embodiment. FIG. 3 is a cross-sectional view of the wiring board illustrated in FIG. 2 in a middle state of a manufacturing process of the wiring board.

As illustrated in FIG. 2, the wiring board 20 according to the embodiment includes a multilayer substrate 22 formed by a glass epoxy or the like. A plurality of wiring layers 24-1, 24-2 and 24-3 are formed in an interior of the multilayer substrate 22.

In the present embodiment, a through hole (penetrating hole) 26-1 and non-through holes (non-penetrating holes) 26-2 and 26-3 are formed in the multilayer substrate 22. The through hole 26-1 is an opening penetrating the multilayer substrate 22 and extending between a front surface 22a and a back surface 22b. A plated layer 28-1 of the through hole 26-1 is connected to the wiring layer 24-1, which is formed at a position in the vicinity of the back surface 22b of the multilayer substrate 22.

On the other hand, the non-through hole 26-2 does not penetrate the multilayer substrate 22 as illustrated in FIG. 3, and has a depth to a middle of the thickness of the multilayer substrate 22. A plated layer 28-2 of the through hole 26-2 is connected to the wiring layer 24-2 in the vicinity of an end of the non-through hole 26-2. As illustrate in FIG. 2, a penetrating hole referred to as a vent hole 30-1 is formed between the end of the non-through hole 26-2 and the back surface 22b of the multilayer substrate 22. An inner diameter of the vent hole 30-1 is smaller than an inner diameter of the plated layer 28-2 provided on an inner surface of the non-through hole 26-2.

The non-through hole 26-3 does not penetrate the multilayer substrate 22 as illustrated in FIG. 3, and has a depth to a position slightly beyond the wiring layer 24-3. A plated layer 28-3 of the non-through hole 26-3 is connected to the wiring layer 24-3 in the vicinity of an end of the non-through hole 26-3. As illustrate in FIG. 2, a penetrating hole referred to as a vent hole 30-2 is formed between the end of the non-through hole 26-3 and the back surface 22b of the multilayer substrate 22. An inner diameter of the vent hole 30-2 is smaller than an inner diameter of the plated layer 28-3 provided on an inner surface of the non-through hole 26-3.

In the present embodiment, the diameter of the vent holes 30-1 and 30-2 is about one half of the diameter of the non-through holes 26-2 and 26-3, which is much smaller than the diameter of the non-through holes 26-2 and 26-3. For example, supposing the thickness of the multilayer substrate 22 is 6.7 mm and the inner diameter of the plated layers 28-2 and 28-3 of the non-through holes 26-2 and 26-3 is 0.55 mm, if the diameter of the vent holes 30-1 and 30-2 is about 0.25 mm to 0.35 mm, a processing liquid and a cleaning liquid can be discharged sufficiently through the vent holes 30-1 and 30-2. However, the thickness of the multilayer substrate 22, the inner diameter of the plated layers 28-2 and 28-3, and the diameter of the vent holes 30-1 and 30-2 are not limited to the above-mentioned numerical values, and can be selected appropriately.

The vent holes 30-1 and 30-2 are formed after the plated layers 28-2 and 28-3 are provided to the non-through holes 26-2 and 26-3. The vent holes 30-1 and 30-2 can be formed by drilling. For example, after providing the plated layers 28-2 and 28-3 to the non-through holes 26-2 and 26-3 as illustrated in FIG. 2, the vent holes 30-1 and 30-2 can be formed by drilling from the side of the back surface 22b of the multilayer substrate 22. The diameter of the drill bit used in the drilling determines the diameter of the vent holes 30-1 and 30-2. Although the drilling may be carried out from the side of the front surface 22a of the multilayer substrate 22, it is not preferable because scrapes created by the drilling are ejected into the non-through holes 26-2 and 26-3. If there is a boring method that does not eject scrapes into the non-through holes 26-2 and 26-3, the vent holes 30-1 and 30-2 may be formed from the side of the front surface 22a of the multilayer substrate 22. Moreover, the forming of the vent holes 30-1 and 30-2 is not limited to the drilling, and other boring method such as, for example, laser machining may be uses.

The connector pins 32-1, 32-2 and 32-3 are press fitted and mounted to the through hole 26-1 and the non-through holes, respectively. FIG. 4 is a cross-sectional view of a part of the wiring board 20 in the state where the connector pins 32-1, 32-2 and 32-3 are press fitted. A length of the press-fitting portion of each of the connector pins 32-1, 32-2 and 32-3 is almost equal to or shorter than a distance from the front surface 22a to each of the wiring layers 24-1, 24-2 and 24-3 in the through hole 26-1 and the non-through holes 26-2 and 26-3. That is, the depths of the non-through holes 26-2 and 26-3 are longer than the length of the press fitting portions of the connector pins 32-2 and 32-3.

With the wiring board 20 of the above mentioned structure, through holes having an unnecessary portions, which do not need to be plated, are replaced by the non-through holes 26-2 and 26-3, the unnecessary portions, which do not need to be plated, is not formed. Thereby, there is no need to remove such unnecessary portions, which do not need to be plated, and, thus, there is no problem occurring due to the back drill.

Moreover, because the vent holes 30-1 and 30-2 communicating with the non-through holes 26-2 and 26-3 are provided, even if a corrosive processing liquid or the like enters the non-through holes 26-2 and 26-3 in a manufacturing process after forming the non-through holes 26-2 and 26-3, the corrosive processing liquid does not remain in the non-through holes 26-2 and 26-3. That is, the corrosive processing liquid entering deep portions of the non-through holes 26-2 and 26-3 can be discharged outside through the vent holes 30-1 and 30-2. Alternatively, because air can be supplied to the non-through holes 26-2 and 26-3 through the vent holes 30-1 and 30-2, the processing liquid remaining in the deep portions of the non-through holes 26-2 and 26-3 can be discharged from the opening side of the non-through holes 26-2 and 26-3 on the front surface 22a of the multilayer substrate 22.

Because the diameter of the vent holes 30-1 and 30-2 is smaller than the inner diameter of the plated layers 28-2 and 28-3 of the non-through holes 26-2 and 26-3, the plated layers 28-2 and 28-3 are not cut off when forming the vent holes 30-1 and 30-2 by drilling. Thus, there are no scrapes of the plated layers being created.

Moreover, because the diameter of the vent holes 30-1 and 30-2 can be much smaller than the diameter of the non-through holes 26-2 and 26-3, an area occupied by the vent holes 30-1 and 30-2 on the back surface 22b of the multilayer substrate 22 is much smaller than an area occupied by portions to be removed by the back drill, which is carried out to remove the plated layers of the through holes. Accordingly, by providing the vent holes 30-1 and 30-2 having a small diameter, wiring layers can be provided in a portion which is to be removed if the back drill is carried.

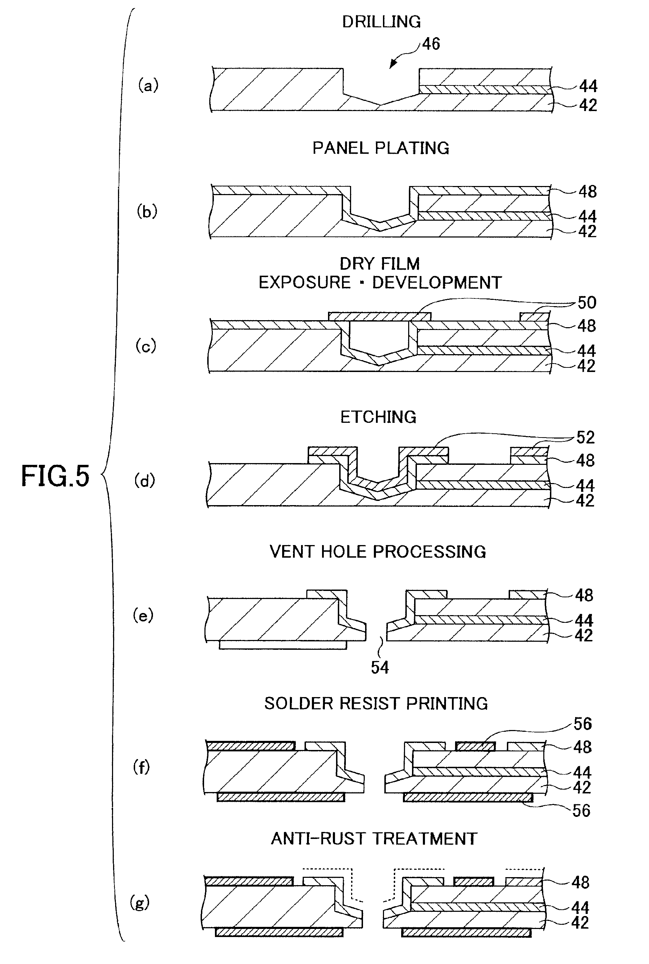

Here, a description will be given, with reference to FIG. 5, of a forming process of the non-through hole and the vent hole. With the example illustrated in FIG. 5, the forming process of the non-through hole and the vent hole is explained mainly, and shape of the substrate and the holes are simplified for the sake of convenience of illustration.

First, as illustrated in FIG. 5-(a), a non-through hole 46 is formed in a substrate 42. The substrate 42 is a multilayer substrate and a wiring layer 44 is formed in the interior of the substrate 42. The non-through hole 46 is formed by drilling and has a depth to reach the wiring layer 44. Then, as illustrate in FIG. 5-(b), panel plating is applied to the entire surface of the substrate 42 by, for example, copper plating. Thereby, a plated layer 48 is formed on an inner surface of the non-through hole 46. It should be noted that, when forming a both-side wiring board, the panel plating is also applied to the back surface of the substrate 42.

Thereafter, as illustrated in FIG. 5-(c), a dry film 50 is applied to a periphery of the non-through hole 46 and a portion where a wiring pattern is formed, and the dry film 50 is exposed and developed. Thereby, a mask 52 is formed as illustrated in FIG. 5-(d), and etching of the plated layer of the panel plating is performed using the mask 52.

Then, a vent hole 54 is formed after removing the mask 52, as illustrated in FIG. 5-(e). After forming the vent hole 54, a solder resist 56 is applied to a portion on the substrate 42 other than the plated portion as illustrated in FIG. 5-(f), and the solder resist 56 is cured. At this time, the solder resist 56 is not applied to a portion where the vent hole 54 is open so that the vent hole 54 on the back side of the substrate 42 is not closed by the solder resist 56. After forming the solder resist 56, finally, an anti-rust treatment is applied to a portion where the panel plated portion is exposed (the plated layer and the wiring indicated by dotted lines in the figure) as illustrated in FIG. 5-(g).

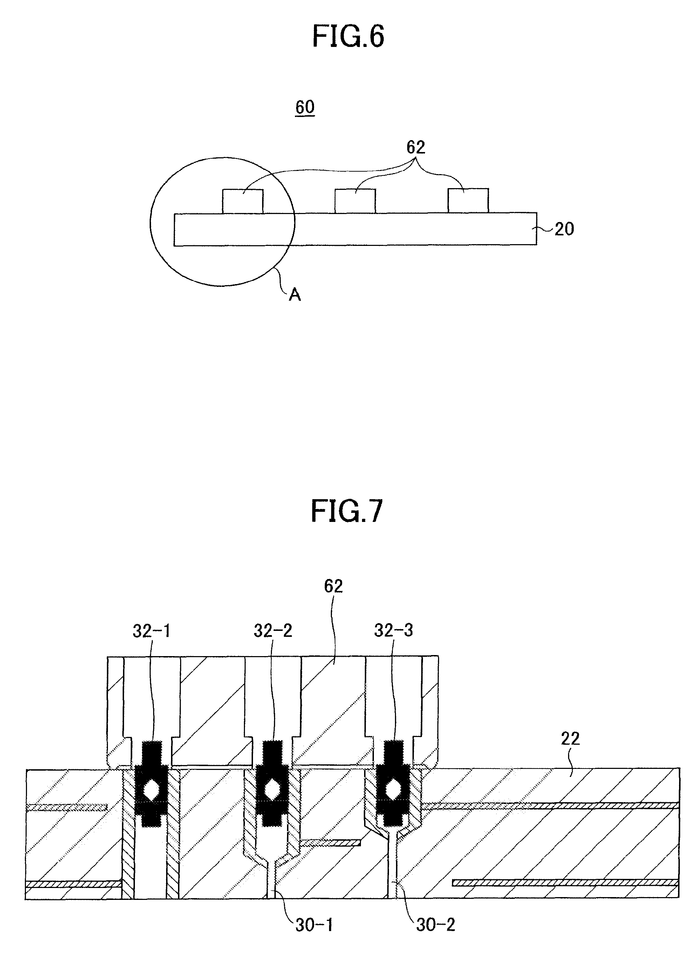

FIG. 6 is a side view of a wiring board assembly 60 formed by attaching a connector to the wiring board according to the above-mentioned embodiment. The wiring board assembly 60 includes the wiring board 20 and the connector 62 fixed on the wiring board 20. FIG. 7 is an enlarged cross-sectional view of a part A of FIG. 6. Portions of the connector pins 32-1, 32-2 and 32-3 protruding from the multilayer substrate 22 are accommodated in the connector 62 so as to serve as connection terminals of the connector 62.

The wiring board 20 can be used as a motherboard incorporated in electronic equipments such as a server. A plurality of wiring boards such as daughter boards are connectable to the mother board (wiring board 20) using the connector 62.

All examples and conditional language recited herein are intended for pedagogical purposes to aid the reader in understanding the principles of the invention and the concepts contributed by the inventor to furthering the art, and are to be construed a being without limitation to such specifically recited examples and conditions, nor does the organization of such examples in the specification relates to a showing of the superiority and inferiority of the invention. Although the embodiment(s) of the present invention (s) has(have) been described in detail, it should be understood that the various changes, substitutions, and alterations could be made hereto without departing from the spirit and scope of the invention.

## Claims

1. A wiring board comprising:
a substrate having a first surface and a second surface opposite to the first surface, at least one wiring layer being formed between the first surface and the second surface; and
at least one non-through hole formed in the substrate with a depth from the first surface to reach the wiring layer, an inner surface of the non-through hole being plated,
**characterized in that**:
a vent hole is formed in the substrate to extend between an end of the non-through hole and the second surface of the substrate;
a plated portion of the non-through hole is connected to the wiring layer; and
an inner diameter of the vent hole is smaller than an inner diameter of the plated portion of the non-through hole.

2. The wiring board according to claim 1, wherein:
the substrate is a multilayer substrate in which a plurality of the wiring layers are formed between the first surface and the second surface;
a plurality of the non-through holes are formed each having a depth corresponding to a respective one of the wiring layers; and
the vent hole is formed to each of the non-through holes.

3. The wiring board according to claim 1 or 2, further comprising a though hole penetrating the substrate to extend between the first surface and the second surface, wherein an inner surface of the through hole is plated, and a plated portion of the through hole is connected to one of the wiring layers which one is formed in a vicinity of the second surface of the substrate.

4. A wiring board assembly, comprising:
a wiring board according to any one of claims 1 to 3;
a connector pin mounted to the substrate of the wiring board by being press fitted into the non-through hole; and
a connector mounted to the substrate of the wiring board so as to accommodate the connector pin.

5. A manufacturing method of a wiring board having a surface in which a wiring layer is formed, the method comprising:
forming a non-through hole with a predetermined depth from a first surface of the substrate; and
applying plating to an inner surface of the non-through hole so as to connect a plated portion to the wiring layer,
**characterized by**:
forming a vent hole extending between an end of the non-though hole and a second surface of the substrate opposite to the first surface and having an inner diameter smaller than an inner diameter of the plated portion of the non-through hole.

6. The manufacturing method according to claim 5, wherein forming the non-though hole includes drilling the substrate from a side of the first surface of the substrate.

7. The manufacturing method as claimed in claim 5, wherein forming the vent hole includes drilling the substrate from a side of the second surface of the substrate.

8. The manufacturing method as claimed in any one of claims 5 to 7, wherein the substrate includes a plurality of the wiring layers, and forming the non-though hole includes forming a plurality of the non-through holes each having a depth corresponding to a respective one of the wiring layers.
